# EUROPEAN PATENT APPLICATION

(11) **EP 2 180 595 A1**
(43) Date of publication of application: **28.04.2010**
(21) Application number: 08832206.0
(22) Date of filing: 09.09.2008
(51) Int. Cl.: H03F 3/24, H03F 1/30, H03F 3/193, H03F 3/60, H05K 1/18

(54) **HIGH OUTPUT POWER AMPLIFIER, WIRELESS TRANSMITTER, WIRELESS TRANSMITTING AND RECEIVING DEVICE, AND HIGH OUTPUT POWER AMPLIFIER MOUNTING METHOD**

(30) Priority: 21.09.2007 JP 2007245593
(71) Applicant: Nec Corporation, Tokyo 108-8001 (JP)
(72) Inventor: ISHINO, Tooru, Tokyo 108-8001 (JP)
(74) Representative: Betten & Resch
(86) International application number: PCT/JP2008/066262
(87) International publication number: WO 2009/037995

(57) **Abstract**

A high power amplifier that has a high heat dissipation effect and is produced at low cost, a wireless transmitter and a wireless transceiver with the high power amplifier and a method for mounting a high power amplifier are provided. The high power amplifier comprises a transistor with lead wires extending from both side surfaces of a mold provided on a heat dissipation member to the outside, a double-sided wiring board of which the heat dissipation member is inserted in an opening of the double-sided wiring board and a wiring pattern on one surface of the double-sided wiring board is electrically connected to the lead wires, and a case for accommodating the double-sided wiring board. Further, the high power amplifier comprises a plate of which one main surface is in contact with an inner wall of the case and the other main surface is connected to the heat dissipation member and a wiring pattern on the other main surface of the double-sided wiring board.

## Description

### [Technical field]

The present invention relates to a high power amplifier, a wireless transmitter, a wireless transceiver and a method for mounting a high power amplifier.

### [Background art]

In a high frequency (usually referred to as RF (Radio Frequency)) high power amplifier using a large output power field effect transistor (usually referred to as FET (Field Effect Transistor)) that is used for a transmitter of a telephone base station or the like at present, a method in which the FET is mounted to a small block by soldering is widely applied at present as a FET mounting method. This method has advantages in which a good heat dissipation characteristic and a good electrical contact stability can be obtained.

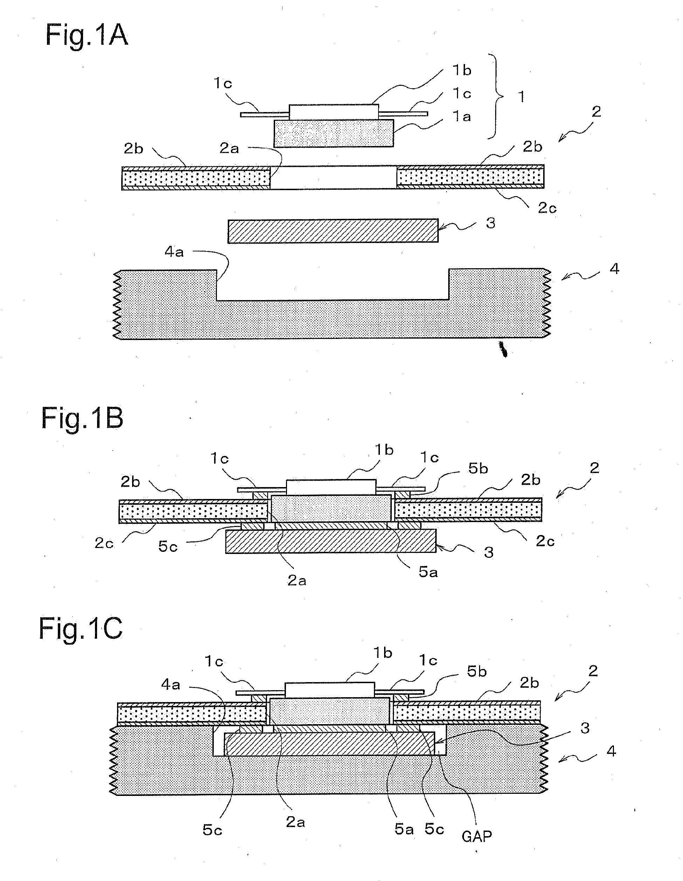

Fig. 1A to Fig. 1C are process drawings illustrating a method for mounting a high power amplifier related to the present invention.
The method for mounting a high power amplifier related to the present invention will be described with reference to Fig. 1A to Fig. 1C.
First, a transistor 1 with lead wires 1c extending from both side surfaces of a mold 1b provided on a heat dissipation member 1a to the outside, a double-sided wiring board (usually referred to as PWB (Print Wire Board)) 2, a block 3 and a case 4 are arranged. An opening 2a into which the heat dissipation member 1a of the transistor 1 can be inserted is formed on the double-sided wiring board 2 and an opening 4a in which the block 3 can be accommodated is formed on the case 4 (Fig. 1A).

Next, the heat dissipation member 1a is inserted into the opening 2a of the double-sided wiring board 2, and an electrical connection between a wiring pattern 2b on one surface (upper surface in the Figure) of the double-sided wiring board 2 and the lead wire 1c and an electrical connection between the heat dissipation member 1a of the transistor 1 and the block 3 are made by solders 5a to 5c (Fig. 1B).
Finally, the double-sided wiring board 2 on which the transistor 1 and the block 3 are mounted is accommodated in the case 4 so that the block 3 is arranged in the opening 4a of the case 4, and thereby the high power amplifier can be obtained (Fig. 1C).

Here, there are patent documents 1 to 4 each which describes a related art to the present invention.
A power amplifier mounting board described in the patent document 1 includes a board on which a concave portion is formed and a conductive plate which is formed in the concave portion with an area in which a field effect transistor can be mounted, has a heat dissipation structure having a convex shape whose height is the same as the thickness of the board, and is led to a lower surface of the board in the power amplifier mounting board.
Man hours and cost for the assembly can be reduced by using the power amplifier mounting board.

A direct-mount power amplifier described in patent document 2, in a power amplifier used for the compact telephone device, includes a main board on which a circuit of a compact telephone device is formed and each of components is mounted and a power amplifier directly mounted on the main board. Accordingly, the device directly mounted on the main board can be integrally adjusted.

According to the direct-mount power amplifier, as a power amplifier for transmission with a main board of a mobile phone, a circuit pattern is formed on the main board of the mobile phone, the power amplifier is directly mounted on the main board and the power amplifier for transmission is obtained. Therefore, the most proper characteristic can be easily and totally obtained by adjusting a variable capacitor that is a mounted component while monitoring an antenna-end characteristic of the mobile phone.

The high power amplifier described in patent document 3 includes a metal subcarrier, a semiconductor device and a microwave signal transmission line that are formed on the metal subcarrier, and a metal heat dissipating plate which is formed between the metal subcarrier and a metal housing and is in contact with the metal subcarrier and the metal housing. In the power amplifier formed above the metal housing, a thermal resistance characteristic value of the material composing the metal heat dissipating plate is lower than those of the materials composing the metal subcarrier and the metal housing, and the metal heat dissipating plate has an area which is wider than a contact area between the metal subcarrier and the metal housing.

By the high power amplifier, a heat dissipation effect can be improved while minimizing an increase in weight.

In a metal case for an electric power module described in patent document 4, a printed wiring board and a semiconductor for power amplification are fixed on the heat dissipating plate by soldering or the like. In a high frequency multi-stage power amplification circuit, the printed wiring board is covered with a metal cap and a surface of the heat dissipating plate is plated with solder.

By using the metal case for an electric power module, as the metal case for an electric power module of the high frequency multi-stage power amplification circuit, the structure, in which the surface of the heat dissipating plate on which the printed wiring board and the semiconductor that needs heat dissipation are fixed by soldering is plated with solder, is applied.
Accordingly, a solder wettability is improved, a heat conduction efficiency from the semiconductor to the heat dissipating plate is improved, and, hence, the semiconductor is suppressed from being heated.
[patent document 1] Japanese Patent Application Laid-Open No. 2001-250881
[patent document 2] Japanese Patent Application Laid-Open No. 1992-3498
[patent document 3] Japanese Patent Publication No. 2970530
[patent document 4] Japanese Patent Publication No. 1995-28153

### [Disclosure of the invention]

### [Problems to be solved by the invention]

However, in the mounting method shown in Fig. 1A to Fig. 1C, a gap between the block and the case is formed because of a problem of machining accuracy. In order to avoid discontinuity of an RF ground caused by the gap, it is necessary to connect a pattern on a rear surface of the double-sided wiring board and the transistor by soldering. This will cause an increase in production cost and occurrence of the other mechanical error.

In the invention described in patent document 1, the copper plate having a convex portion at a center thereof is arranged in a concave portion of an epoxy board, the field effect transistor is mounted on the convex portion by soldering, and the copper plate is led to a lower surface of the board. Accordingly, the processing of the copper plate is required and this will cause an increase in cost. Moreover, there is a problem in which the invention cannot be applied to the transistor with a lead wire extending from both side surfaces of a mold provided on the heat dissipation member to the outside.

In the invention described in patent document 2, although the field effect transistor is soldered to the metal plate provided on a rear surface of the board through a rectangular hole of the mounting board, the metal plate is in contact with only the mounting board and is not in contact with the case. Then, there is a problem that the heat dissipation is limited.

In the invention described in patent document 3, it has a the metal heat dissipating plate which is provided to only the convex portion of the metal housing and not provided to the whole surface of the metal housing although the metal heat dissipating plate is provided between the metal subcarrier and the metal housing and is in contact with the metal subcarrier and the metal housing. Therefore, the heat is not sufficiently conducted from the semiconductor device to the outside of the housing and this results in insufficient heat dissipation.

In the invention described in patent document 4, the semiconductor for power amplification is directly fixed by soldering to the heat dissipating plate to which the solder plating is applied through the hole in the printed wiring board. However, there is a problem in which because the gap between the case and the heat dissipating plate to which the solder plating is applied is formed when it is fixed to the case, the heat is not sufficiently dissipated to the outside of the case and this results in insufficient heat dissipation.

Accordingly, the object of the present invention is to provide a high power amplifier which has a high heat dissipation effect and is produced at low cost, a wireless transmitter, a wireless transceiver and a method for mounting a high power amplifier.

### [Means for solving the problems]

A first device of the present invention is a high power amplifier including a transistor with lead wires extending from both side surfaces of a mold provided on a heat dissipation member to the outside, a double-sided wiring board of which the heat dissipation member is inserted in an opening of the double-sided wiring board and a wiring pattern on one surface of the double-sided wiring board is electrically connected to the lead wires, and a case for accommodating the double-sided wiring board, and characterized by comprising a plate of which one main surface is in contact with an inner wall of the case and the other main surface is connected to the heat dissipation member and a wiring pattern on the other main surface of the double-sided wiring board.

A second device of the present invention is a wireless transmitter including a circuit for generating a carrier wave, an amplification circuit for amplifying a voice signal, a modulation circuit for modulating the carrier wave by the voice signal from the amplification circuit, and a power amplification circuit for amplifying an output of the modulation circuit, and **characterized in that** the above mentioned high power amplifier is used in the power amplification circuit.

A third device of the present invention is a wireless transceiver including a transmission unit that includes a circuit for generating a carrier wave, an amplification circuit for amplifying a voice signal, a modulation circuit for modulating the carrier wave by the voice signal from the amplification circuit, and a power amplification circuit for amplifying the output of the modulation circuit, a receiving unit that includes a circuit for performing a frequency conversion of a signal received by an antenna, and a detection circuit for detecting the voice signal from the frequency converted signal, and a changeover switch for connecting the antenna to the transmission unit or the receiving unit by switching, and **characterized in that** the above mentioned high power amplifier is used in the power amplification circuit.

A first method of the present invention is characterized by comprising: arranging a plate, a double-sided wiring board, a transistor with lead wires extending from both side surfaces of a mold provided on a heat dissipation member to the outside and a case; bonding the double-sided wiring board to the plate; inserting a heat dissipation member of the transistor in an opening of the double-sided wiring board and making an electrical connection between a wiring pattern on an exposed surface of the double-sided wiring board and the lead wires and between the plate and the heat dissipation member of the transistor; and bonding the plate on an inner wall of the case.

### [Advantage of the invention]

The present invention includes a plate whose one main surface is in contact with the inner wall of the case and whose the other main surface is connected to the heat dissipation member of the transistor and the wiring pattern on the other main surface of the double-sided wiring board. Accordingly, man hours and a cost become low because the processing of the plate is not required. Additionally, because the plate is in contact with the inner wall of the case, an effect of dissipating heat to the outside of the case of the transistor is improved.

### [Best mode for carrying out the invention]

The present invention has advantages that a stable electrical characteristic and heat dissipation characteristic can be well realized over the long term as a high power amplifier using a transistor, because the transistor is connected to a large-area metal plate by soldering.

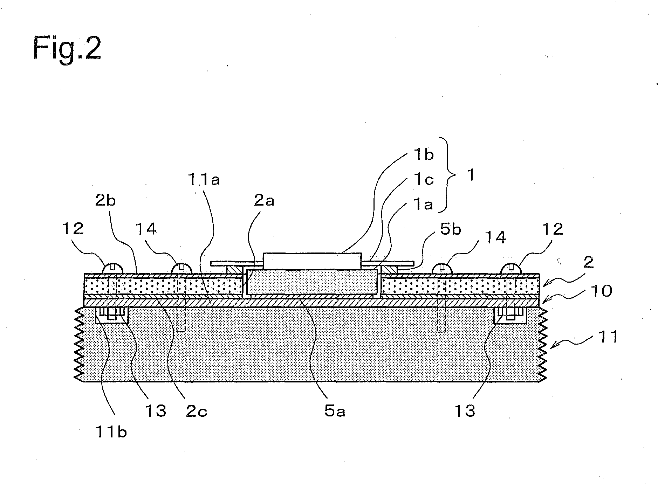

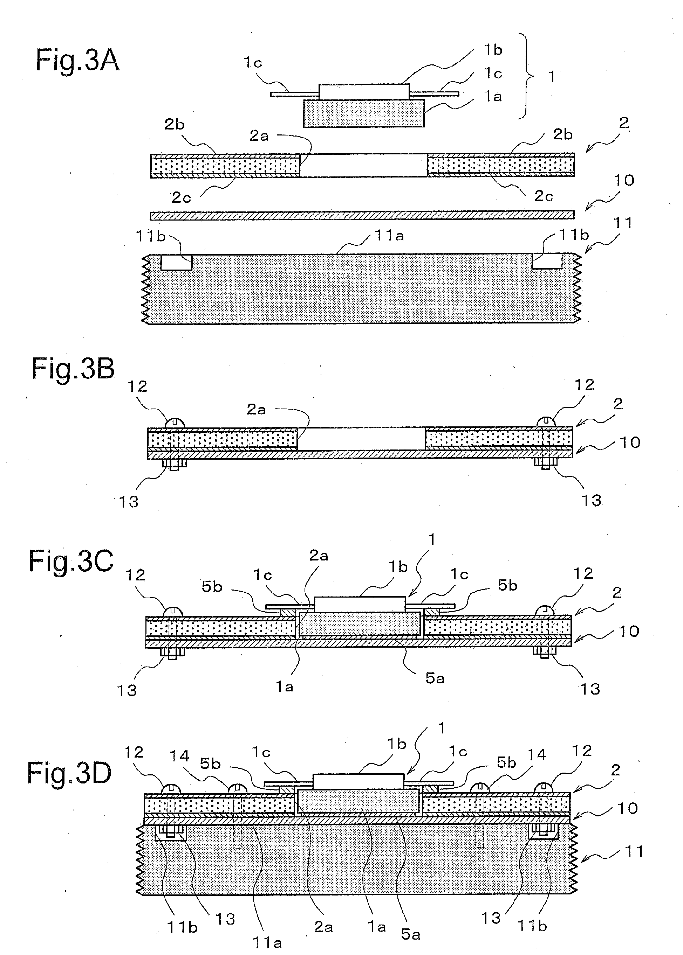

Fig. 2 is a structural drawing showing an exemplary embodiment of a high power amplifier according to the present invention, and Fig. 3A to Fig. 3D are examples of process drawings illustrating a method for mounting the high power amplifier shown in Fig. 2. Further, the same reference numbers are used for the members that are the same as the members shown in Fig. 1A to Fig. 1C.
The high power amplifier shown in Fig. 2 includes the transistor 1 with lead wires 1c extending from both side surfaces (right side surface and left side surface shown in the Figure) of the mold 1b provided on the heat dissipation member 1a to the outside, the double-sided wiring board 2 in which the heat dissipation member 1a is inserted in the opening 2a and the wiring pattern 2b on one surface (upper surface shown in the Figure) is electrically connected to the lead wire 1c, and a case 11 for accommodating the double-sided wiring board 2. The high power amplifier is characterized by comprising a plate 10 whose one main surface (in this case, lower side surface) is in contact with an inner wall 11a of the case 11 and whose the other main surface (in this case, upper side surface) is connected to the heat dissipation member 1a and a wiring pattern 2c on the other main surface of the double-sided wiring board 2.

For example, a high power field effect transistor (MRF6S21100HSR3 manufactured by Free scale Semiconductor Corp.) called power FET that needs a heat dissipating plate is used for the transistor 1.
For example, a gold plating copper plate or a tin plating copper plate or others are used for the plate 10.
For example, a case made of aluminum or duralumin or others is used for the case 11. 11b is a concave portion for accommodating a nut 13 when the double-sided wiring board 2 is installed in the case 11. The nut 13 is explained later.

Next, one exemplary embodiment of the method for mounting a high power amplifier according to the present invention will be described with reference to Fig. 3A to Fig. 3D.
First, the transistor 1 with lead wires 1c extending from both side surfaces of the mold 1b provided on the heat dissipation member 1a to the outside, the double-sided wiring board 2, the plate 10, and the case 11 are arranged.
The opening 2a in which the heat dissipation member 1a of the transistor 1 is to be inserted is formed on the double-sided wiring board 2, and a size of the plate 10 is equal to or larger than that of the double-sided wiring board 2 (Fig. 3A).

The double-sided wiring board 2 is bonded to the plate 10, and the double-sided wiring board 2 and the plate 10 are fixed by a screw 12 and the nut 13 (Fig. 3B).

The heat dissipation member 1a of the transistor 1 is inserted in the opening 2a of the double-sided wiring board 2. The electrical connection between the wiring pattern 2b on the exposed surface of the double-sided wiring board 2 and the lead wire 1c is made by solder reflow, and the electrical connection between the heat dissipation member 1a of the transistor 1 and the plate 10 is made by solder reflow. The other electronic components (not shown) are mounted at the time of the solder reflow. It is desirable to apply a solder paste to the lead wire 1c, the wiring pattern 2b of the double-sided wiring board 2 and the plate 10 at the time of the solder reflow in advance despite a mounting other electronic components (not shown).
The solder paste is applied to the heat dissipation member 1a (for example, a copper-molybdenum laminate or a gold plating copper plate) of the transistor 1, a rear surface of the lead wire 2c and one surface of the double-sided wiring board 2 (upper surface in the Figure).
The solder is melted by the reflow in a state in which the heat dissipation member 1a of the transistor 1 is inserted in the opening 2a of the, double-sided wiring board 2 and the other electronic components (not shown) are mounted. Accordingly, the wiring pattern 2b on one surface (upper surface in the Figure) of the double-sided wiring board 2 is electrically connected to the rear surface (in this case, lower side) of the lead wire 1c (Fig. 3C).

The double-sided wiring board 2 on which the electronic components such as the transistor 1 and the like are mounted is accommodated in the case 11, and the double-sided wiring board 2 is fixed by a screw 14 so that the plate 10 is in contact with the inner wall 11a of the case 11. Then, the high power amplifier is obtained (Fig. 3D).

Here, a size of the block 3 used for the high power amplifier shown in Fig. 1A to Fig. 1C is smaller than that of the double-sided wiring board 2, and the size in area of the block 3 is approximately equal to that of the transistor 1. Meanwhile, a size in area of the plate 10 used for the high power amplifier according to the present invention is approximately equal to that of the double-sided wiring board 2, and the plate 10 exists under at least the area within which the entire microstrip line exists. Therefore, the plate 10 itself can be employed as a common RF ground for the transistor 1 and the double-sided wiring board 2. Accordingly, discontinuity of the RF ground which exists at the end of the block 3 does not occur, soldering to the double-sided wiring board 2 is not required and, hence, the man hours for the assembly is reduced.
Further, in the exemplary embodiment mentioned above, a case in which a field effect transistor is employed as the transistor is described. However, the present invention is not limited to this and a bipolar transistor may be used.

### [Description of the effect]

Reduction of a manufacturing cost and improvement of mechanical accuracy in a vertical direction can be realized because the soldering between the plate and the double-sided wiring board is not needed.

Further, the above mentioned exemplary embodiment shows an example of the preferred embodiment of the present invention, the present invention is not limited to this, and the variations of the present invention are acceptable without departing from the scope of the invention. For example, in the above-mentioned description, although the explanation has been made with respect to the high power amplifier, the present invention is not limited to this and the present invention can be applied to a transmitter or a transceiver.

### [Other exemplary embodiments]

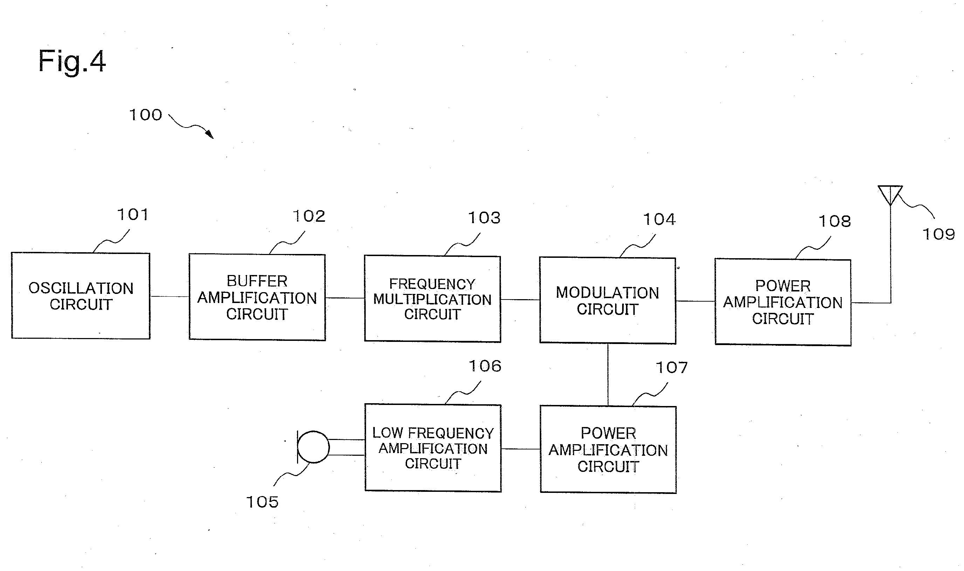

Fig. 4 is a block diagram showing an exemplary embodiment of a wireless transmitter according to the present invention.
The wireless transmitter shown in the Figure is a transmitter of an amplitude-modulation type, and its transmitted electric wave is A3 type. But the wireless transmitter is not limited to mentioned above.
A wireless transmitter 100 shown in the Figure is composed of a well-known oscillation circuit 101, a buffer amplification circuit 102, a frequency multiplication circuit 103, a modulation circuit 104, a microphone 105, a low frequency amplification circuit 106, a power amplification circuits 107 and 108, and an antenna 109.

A signal oscillated by the oscillation circuit (for example, crystal oscillation circuit) 101 is sent to the frequency multiplication circuit 103 through the buffer amplification circuit 102 and is multiplied by the frequency multiplication circuit 103 in order to obtain a carrier wave of a desired frequency. A voice inputted to the microphone 105 is converted into an electrical signal. The electrical signal is voltage-amplified by the low frequency amplification circuit 106 and power-amplified by the power amplification circuit 107. The carrier wave from the frequency multiplication circuit 103 and the voice signal from the power amplification circuit 107 are modulated by the modulation circuit 104, amplified by the power amplification circuit 109 and radiated from the antenna 109 as the electric wave.
By applying this power amplification circuit 108 to the high power amplifier of the present invention, reduction of a manufacturing cost and improvement of mechanical accuracy in a vertical direction can be realized.

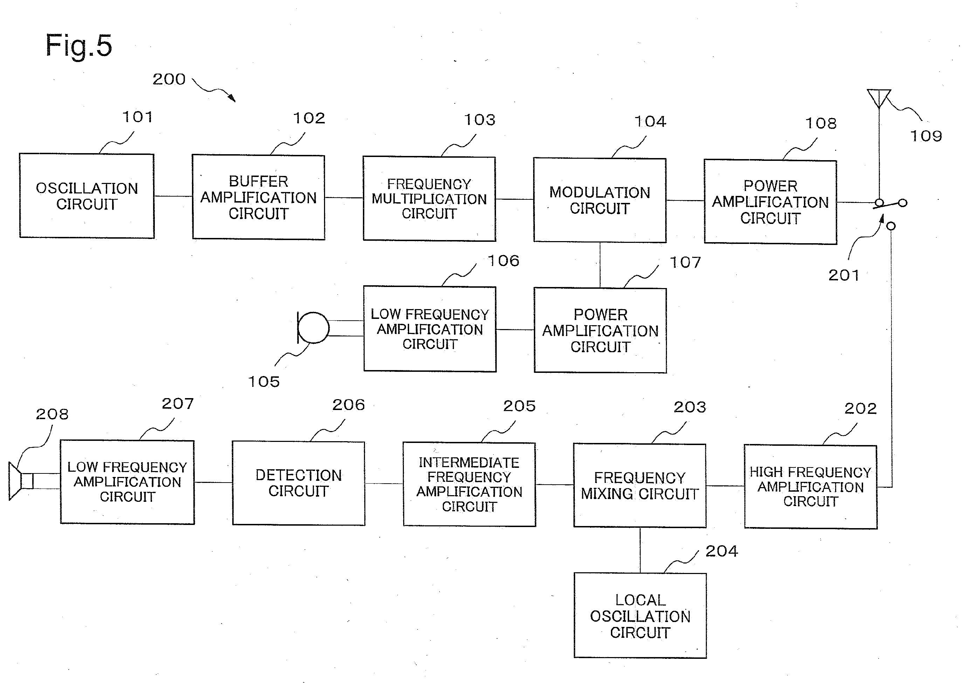

Fig. 5 is a block diagram showing an exemplary embodiment of a wireless transceiver according to the present invention.
A wireless transceiver 200 shown in the Figure is composed of a transmission unit, a receiving unit, a changeover switch 201 and the antenna 109.
The explanation of the transmission unit will be omitted because the transmission unit is similar to the wireless transmission unit shown in Fig. 3.
The receiving unit is a well-known super-heterodyne type receiving unit and is composed of a high frequency amplification circuit 202, a frequency mixing circuit 203, a local oscillation circuit 204, an intermediate frequency amplification circuit 205, a detection circuit 206, a low frequency amplification circuit 207 and a speaker 208.

In the receiving unit, when a contact of the changeover switch 201 is connected to the antenna 109 side, the received electric wave is amplified by the high frequency amplification circuit 202. The amplified electric wave is applied to a frequency-convert and is converted to an intermediate frequency by the frequency mixing circuit 203 and the local oscillation circuit 204. The converted electric wave is amplified by an intermediate amplification circuit 205 and is detected by the detection circuit 206 as a voice signal. The voice signal detected by the detection circuit 206 is amplified by the low frequency amplification circuit 207 and is generated from the speaker 208.
By applying this power amplification circuit 108 to the high power amplifier of the present invention, reduction of a manufacturing cost and improvement of mechanical accuracy in a vertical direction can be realized.

This application is based upon and claims the benefit of priority from Japanese patent application No. 2007-245593, filed on September 21, 2007, the disclosure of which is incorporated herein in its entirety by reference.

### [Industrial applicability]

The present invention can be used for a wireless transmitter, a wireless transceiver, or the like and has industrial applicability.

### [Brief description of the drawings]

[Figure. 1]
   Fig. 1 is a process drawing illustrating a method for mounting a high power amplifier according to the present invention.
[Figure. 2]
   Fig. 2 is a structural drawing showing an exemplary embodiment of a high power amplifier according to the present invention.
[Figure. 3]
   Fig. 3A to Fig. 3D are examples of process drawings illustrating a method for mounting the high power amplifier shown in Fig. 2.
[Figure. 4]
   Fig. 4 is a block diagram showing an exemplary embodiment of a wireless transmitter according to the present invention.
[Figure. 5]
   Fig. 5 is a block diagram showing an exemplary embodiment of a wireless transceiver according to the present invention.

### [Description of symbol]

- 1: transistor
- 1a: heat dissipation member
- 1b: mold
- 1c: lead wire
- 2: double-sided wiring board
- 2a: opening
- 2b, 2c: wiring pattern
- 10: plate
- 11: case
- 11a: inner wall
- 11b: concave portion
- 12, 14: screw
- 13: nut

## Claims

1. A high power amplifier comprising:
a transistor with lead wires extending from both side surfaces of a mold provided on a heat dissipation member to the outside;
a double-sided wiring board having an opening in which the heat dissipation member is inserted and one surface where a wiring pattern is electrically connected to the lead wires; and
a case for accommodating the double-sided wiring board:
wherein the high power amplifier further comprises a plate of which one main surface is in contact with an inner wall of the case and the other main surface is connected to the heat dissipation member and the wiring pattern on the other main surface of the double-sided wiring board.

2. The high power amplifier according to claim 1,
wherein a size of said plate is equal to or larger than that of said double-sided wiring board.

3. The high power amplifier according to claim 1 or 2,
wherein said lead wire is soldered to the wiring pattern on one surface of said double-sided wiring board, and said case, said plate and said double-sided wiring board are connected by using a screw.

4. A wireless transmitter comprising:
a circuit for generating a carrier wave;
an amplification circuit for amplifying a voice signal;
a modulation circuit for modulating the carrier wave by the voice signal from the amplification circuit; and
a power amplification circuit for amplifying an output of the modulation circuit:
wherein the high power amplifier according to any one of claims 1 to 3 is used for said power amplification circuit.

5. A wireless transceiver comprising:
a transmission unit that comprises a circuit for generating a carrier wave, an amplification circuit for amplifying a voice signal, a modulation circuit for modulating the carrier wave by the voice signal from the amplification circuit, and a power amplification circuit for amplifying an output of the modulation circuit;
a receiving unit that comprises a circuit for performing a frequency conversion of a signal received by an antenna, and a detection circuit for detecting a voice signal from the frequency converted signal; and
a changeover switch for connecting the antenna to the transmission unit or the receiving unit by switching;
wherein the high power amplifier according to any one of claims 1 to 3 is used for said power amplification circuit.

6. A method for mounting a high power amplifier comprising:
arranging a plate, a double-sided wiring board, a transistor with lead wires extending from both side surfaces of a mold provided on a heat dissipation member to the outside and a case;
bonding the double-sided wiring board to the plate;
inserting a heat dissipation member of the transistor into an opening of the double-sided wiring board, making an electrical connection between a wiring pattern on an exposed surface of the double-sided wiring board and the lead wires, and making an electrical connection between the plate and the heat dissipation member of the transistor; and
bonding the plate to an inner wall of the case.

7. The method for mounting a high power amplifier according to claim 6 further comprising:
fixing said plate to said double-sided board by a screw;
making an electrical connection by soldering between a wiring pattern on an exposed surface of said double-sided wiring board and said lead wires, and between said plate and a heat dissipation member of said transistor; and
fixing said plate and said double-sided board to said case by a screw.
